# EUROPEAN PATENT APPLICATION

(11) **EP 4 730 603 A1**
(43) Date of publication of application: **22.04.2026**
(21) Application number: 25205231.1
(22) Date of filing: 29.09.2025
(51) Int. Cl.: H02J 7/60

(54) **METHOD AND SYSTEM FOR PREVENTING UNAUTHORIZED CELL REPLACEMENT**

(30) Priority: 11.10.2024 KR 20240138604
(71) Applicant: SAMSUNG SDI CO., LTD., Yongin-si, Gyeonggi-do 17084 (KR)
(72) Inventor: YOO, Jae Shik, 17084 Yongin-si (KR); SEO, Youngdong, 17084 Yongin-si (KR)
(74) Representative: Marks & Clerk LLP

(57) **Abstract**

The present disclosure provides an unauthorized cell replacement prevention method. The method includes storing first time information generated by a Real Time Clock (RTC) circuit of a battery management system in a memory of the battery management system; determining whether at least some of a plurality of cells associated with the battery management system have been replaced based on the first time information when the battery management system wakes up; and activating a first protection function in response to determining that at least some of the plurality of cells have been replaced, and the plurality of cells supply power to the RTC circuit.

## Description

### FIELD

Aspects of embodiments of the present disclosure relate to a method and system for preventing unauthorized cell replacement.

### BACKGROUND

Unlike primary batteries that are not designed to be (re)charged, secondary (or rechargeable) batteries are batteries that are designed to be discharged and recharged. Low-capacity secondary batteries are used in portable, small electronic devices, such as smart phones, feature phones, notebook computers, digital cameras, and camcorders, while large-capacity secondary batteries are widely used as power sources for driving motors in hybrid vehicles and electric vehicles and for storing power (for example, home and/or utility scale power storage). A secondary battery generally includes an electrode assembly composed of a positive electrode and a negative electrode, a case accommodating the same, and electrode terminals connected to the electrode assembly.

Battery assemblies that include these secondary batteries may need to be replaced due to deterioration and other factors. In this case, unauthorized batteries from private companies might be used instead of the authorized batteries provided by the original manufacturer that manufactured and sold the battery assembly. In this case, there is a potential risk of accidents because the safety of these unauthorized batteries has not been verified, using such batteries can undermine the reliability of the manufacturer.

The herein information disclosed in this Background section is for enhancement of understanding of the background of the present disclosure, and therefore, it may contain information that does not constitute related (or prior) art.

### SUMMARY

Embodiments of the present disclosure provide a method and system for preventing unauthorized cell replacement.

These and other aspects and features of the present disclosure will be described in or will be apparent from the following description of embodiments of the present disclosure.

An unauthorized cell replacement prevention method according to embodiments of the present disclosure includes, storing first time information generated by a Real Time Clock (RTC) circuit of a battery management system in a memory of the battery management system; determining whether at least some of a plurality of cells associated with the battery management system have been replaced based on the first time information when the battery management system wakes up; and activating a first protection function in response to determining that at least some of the plurality of cells have been replaced, and the plurality of cells supply power to the RTC circuit.

According to embodiments, the first time information may be stored in the memory at predetermined intervals during operation of the battery management system.

According to embodiments, the determining whether at least some of the plurality of cells have been replaced may include receiving second time information generated by the RTC circuit after the battery management system wakes up; and determining whether at least some of the plurality of cells have been replaced based on the first time information stored in the memory and the received second time information.

According to embodiments, the determining of whether at least some of the plurality of cells have been replaced based on the second time information may include determining that at least some of the plurality of cells have been replaced if the first time is greater than the second time.

According to embodiments, the first protection function may include opening a relay associated with the battery management system.

According to embodiments, the RTC circuit may be connected to the plurality of cells through a transformer, and the method may include: determining whether the transformer is operating normally based on an output voltage of the transformer; and activating the first protection function in response to determining that the transformer is operating abnormally.

According to embodiments, the method may further include storing third time information generated from the RTC circuit in the memory when the replaced cell is an authorized cell.

According to embodiments, the third time information may be generated after the RTC circuit is initialized.

According to embodiments, the method may further include determining whether to disable the first protection function when the replaced cell is an authorized cell.

According to embodiments, the determining of whether to disable the first protection function may include determining whether to activate a second protection function of the battery management system.

According to embodiments, the determining of whether to disable the first protection function may further include disabling the first protection function if the second protection function is not operating.

According to embodiments, the determining of whether to disable the first protection function may further include activating the first protection function if the second protection function is operating.

According to embodiments, the disabling of the first protection function may include: receiving a disable command from an external device; and disabling the first protection function based on the disable command.

According to embodiments, the disable command may include a unique value corresponding to the battery management system.

According to embodiments, the memory may be a nonvolatile memory.

According to embodiments, the power supplied to the RTC circuit may be cut off when at least some of the plurality of cells are replaced, and the RTC circuit may be initialized when the power supplied to the RTC circuit is cut off.

According to embodiments, the method may further include outputting information associated with the battery management system in response to determining that at least some of the plurality of cells have been replaced.

According to embodiments of the present disclosure, a computer-readable non-transitory recording medium having recorded thereon instructions for executing the unauthorized cell replacement prevention method on a computer is provided.

According to embodiments of the present disclosure, an unauthorized cell replacement prevention system includes, a plurality of cells; and a battery management system for controlling the plurality of cells, wherein the battery management system includes an RTC circuit, a memory, and a controller, the plurality of cells supply power to the RTC circuit, the controller is configured to: store first time information generated by the RTC circuit in the memory of the battery management system; determine whether at least some of the plurality of cells associated with the battery management system have been replaced based on the first time information when the battery management system wakes up; and activate a first protection function in response to determining that at least some of the plurality of cells have been replaced.

According to embodiments, the controller may be configured to: receive second time information generated by the RTC circuit after the battery management system wakes up; and determine whether at least some of the plurality of cells have been replaced based on the first time information stored in the memory and the received second time information.

According to some embodiments of the present disclosure, whether a cell has been replaced can be detected using time information of the RTC circuit. By activating the protection function when a cell is replaced, the operation of the battery management system may be stopped unless a disable command is issued. Accordingly, the operation of the battery management system using an unauthorized cell can be stopped, thereby preventing replacement of an unauthorized cell.

These and other aspects and features of the present disclosure will be described in or will be apparent from the following description of embodiments of the present disclosure.

However, aspects and features of the present disclosure are not limited to those described herein, and other aspects and features not mentioned will be clearly understood by a person skilled in the art from the detailed description, described herein.

At least some of the above and other features of the invention are set out in the claims.

### BRIEF DESCRIPTION OF THE DRAWINGS

The following drawings attached to this specification illustrate embodiments of the present disclosure, and further describe aspects and features of the present disclosure together with the detailed description of the present disclosure. Thus, the present disclosure should not be construed as being limited to the drawings:
FIG. 1 is a diagram illustrating an example of a battery cell according to embodiments of the present disclosure.
FIG. 2 is a cross-sectional view showing an example of a battery cell according to embodiments of the present disclosure.
FIG. 3 is a diagram illustrating an example of an unauthorized cell replacement prevention system according to embodiments of the present disclosure.
FIG. 4 is a diagram illustrating an example of a configuration of a controller according to embodiments of the present disclosure.
FIG. 5 is a flowchart showing an example of an unauthorized cell replacement prevention method according to embodiments of the present disclosure.
FIG. 6 is a diagram illustrating an example of a method for determining whether at least some of a plurality of cells have been replaced according to embodiments of the present disclosure.
FIG. 7 is a diagram illustrating an example of a method for disabling a first protection function according to embodiments of the present disclosure.
FIG. 8 is a diagram illustrating an example of a method for activating a first protection function depending on whether a transformer is operating normally according to embodiments of the present disclosure.

### DETAILED DESCRIPTION

Hereinafter, embodiments of the present disclosure will be described, in detail, with reference to the accompanying drawings. The terms or words used in this specification and claims should not be construed as being limited to the usual or dictionary meaning and should be interpreted as meaning and concept consistent with the technical idea of the present disclosure based on the principle that the inventor can be his/her own lexicographer to appropriately define the concept of the term to explain his/her disclosure in the best way.

The embodiments described in this specification and the configurations shown in the drawings are only some of the embodiments of the present disclosure and do not represent all of the technical ideas, aspects, and features of the present disclosure. Accordingly, it should be understood that there may be various equivalents and modifications that can replace or modify the embodiments described herein at the time of filing this application.

It will be understood that when a layer or element is referred to as being "between" two layers, it can be the only layer between the two layers, or one or more intervening layers may also be present. It will be understood that when an element or layer is referred to as being "on," "connected to," or "coupled to" another element or layer, it may be directly on, connected, or coupled to the other element or layer or one or more intervening elements or layers may also be present. When an element or layer is referred to as being "directly on," "directly connected to," or "directly coupled to" another element or layer, there are no intervening elements or layers present. For example, when a first element is described as being "coupled" or "connected" to a second element, the first element may be directly coupled or connected to the second element or the first element may be indirectly coupled or connected to the second element via one or more intervening elements.

In the figures, dimensions of the various elements, layers, etc., may be exaggerated for clarity of illustration. The same reference numerals designate the same elements. As used herein, the term "and/or" includes any and all combinations of one or more of the associated listed items. Further, the use of "may" when describing embodiments of the present disclosure relates to "one or more embodiments of the present disclosure." Expressions, such as "at least one of" and "any one of," when preceding a list of elements, modify the entire list of elements and do not modify the individual elements of the list. When phrases such as "at least one of A, B and C, "at least one of A, B or C," "at least one selected from a group of A, B and C," or "at least one selected from among A, B and C" are used to designate a list of elements A, B and C, the phrase may refer to any and all suitable combinations or a subset of A, B and C, such as A, B, C, A and B, A and C, B and C, or A and B and C. As used herein, the terms "use," "using," and "used" may be considered synonymous with the terms "utilize," "utilizing," and "utilized," respectively. As used herein, the terms "substantially," "about," and similar terms are used as terms of approximation and not as terms of degree, and are intended to account for the inherent variations in measured or calculated values that would be recognized by those of ordinary skill in the art.

It will be understood that, although the terms first, second, third, etc., may be used herein to describe various elements, components, regions, layers, and/or sections, these elements, components, regions, layers, and/or sections should not be limited by these terms. These terms are used to distinguish one element, component, region, layer, or section from another element, component, region, layer, or section. Thus, a first element, component, region, layer, or section discussed herein could be termed a second element, component, region, layer, or section without departing from the teachings of example embodiments.

Spatially relative terms, such as "beneath," "below," "lower," "above," "upper," and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" or "over" the other elements or features. Thus, the term "below" may encompass both an orientation of above and below. The device may be otherwise oriented (rotated 90 degrees or at other orientations), and the spatially relative descriptors used herein should be interpreted accordingly.

The terminology used herein is for the purpose of describing embodiments of the present disclosure and is not intended to be limiting of the present disclosure. As used herein, the singular forms "a" and "an" are intended to include the plural forms as well, unless the context clearly indicates otherwise. It will be further understood that the terms "includes," "including," "comprises," and/or "comprising," when used in this specification, specify the presence of stated features, integers, steps, operations, elements, and/or components but do not preclude the presence or addition of one or more other features, integers, steps, operations, elements, components, and/or groups thereof.

Also, any numerical range disclosed and/or recited herein is intended to include all sub-ranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein. Accordingly, Applicant reserves the right to amend this specification, including the claims, to expressly recite any sub-range subsumed within the ranges expressly recited herein. All such ranges are intended to be inherently described in this specification such that amending to expressly recite any such subranges would comply with the requirements of local patent laws.

References to two compared elements, features, etc., as being "the same" may mean that they are "substantially the same". Thus, the phrase "substantially the same" may include a case having a deviation that is considered low in the art, for example, a deviation of 5% or less. In addition, when a certain parameter is referred to as being uniform in a given region, it may mean that it is uniform in terms of an average.

Throughout the specification, unless otherwise stated, each element may be singular or plural.

Arranging an arbitrary element "above (or below)" or "on (under)" another element may mean that the arbitrary element may be disposed in contact with the upper (or lower) surface of the element, and another element may also be interposed between the element and the arbitrary element disposed on (or under) the element.

In addition, it will be understood that when a component is referred to as being "linked," "coupled," or "connected" to another component, the elements may be directly "coupled," "linked" or "connected" to each other, or another component may be "interposed" between the components".

Throughout the specification, when "A and/or B" is stated, it means A, B or A and B, unless otherwise stated. That is, "and/or" includes any or all combinations of a plurality of items enumerated. When "C to D" is stated, it means C or more and D or less, unless otherwise specified.

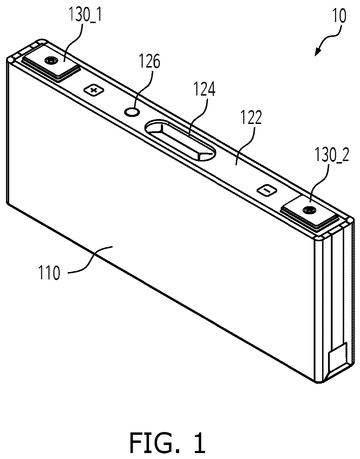

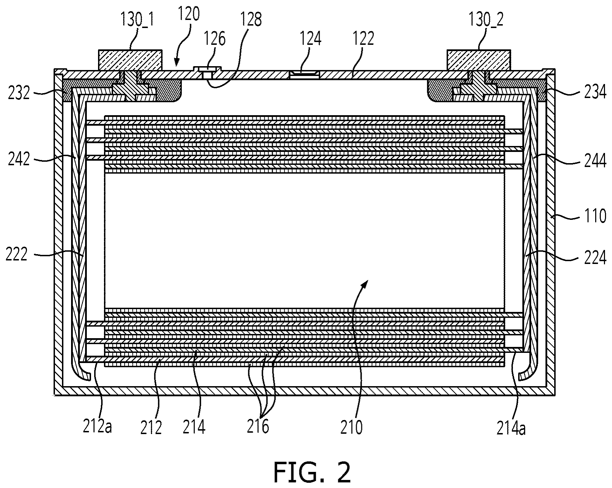

FIG. 1 is a diagram illustrating an example of a battery cell 10 according to embodiments of the present disclosure, and FIG. 2 is a cross-sectional view showing an example of a battery cell 10 according to embodiments of the present disclosure. Referring to FIGS. 1 and 2, the secondary battery 10 according to one or more embodiments of the present disclosure may include at least one electrode assembly 210 wound with a separator 216 as an insulator between the positive electrode 212 and the negative electrode 214, a case 110 in which the electrode assembly 210 is received (or accommodated) therein, and a cap assembly 120 coupled to an opening of the case 110.

The secondary battery 10 according to one or more embodiments will now be described as an example of a prismatic lithium ion secondary battery. However, the present disclosure is not limited thereto, and suitable aspects, features and principles described herein may be applied to various other types of batteries, such as lithium polymer batteries and/or cylindrical batteries.

Each of the positive electrode 212 and the negative electrode 214 may include a current collector made of a thin metal foil having a coated portion on which an active material is coated and an uncoated portion 212a, 214a on which an active material is not coated.

The positive electrode 212 and the negative electrode 214 are wound after interposing the separator 216, which is an insulator, therebetween. However, the present disclosure is not limited thereto, and the electrode assembly 210 may have a structure in which a positive electrode 212 and a negative electrode 214, each made of a plurality of sheets, are alternately stacked with a separator interposed therebetween.

The case 110 may form the overall outer appearance of the secondary battery 10 and may be made of a conductive metal, such as aluminum, aluminum alloy, or nickel-plated steel. In addition, the case 110 may provide a space in which the electrode assembly 210 is accommodated.

The cap assembly 120 may include a cap plate 122 covering an opening in the case 110, and the case 110 and the cap plate 122 may be made of a conductive material. The positive and negative electrode terminals 130_1 and 130_2 electrically connected to the positive electrode 212 and the negative electrode 214, respectively, may be installed to penetrate (or extend through) the cap plate 122 and protrude outwardly therethrough.

In addition, outer peripheral surfaces (for example, circumferential surfaces) of upper pillars of the positive and negative electrode terminals 130_1 and 130_2 protruding outwardly from the cap plate 122 may be threaded and may be fixed to the cap plate 122 by utilizing nuts.

However, the present disclosure is not limited thereto, and the positive and negative electrode terminals 130_1 and 130_2 may have a rivet structure and may be riveted or welded to the cap plate 122.

In addition, the cap plate 122 may be made of a thin plate and may be coupled to the opening in the case 110, and an electrolyte injection port 128 into which a sealing stopper 126 may be installed may be located (for example, formed) in the cap plate 122, and a vent portion 124 having a notch may be installed.

The positive and negative electrode terminals 130_1 and 130_2 may be electrically connected to current collectors including first and second current collectors 222 and 224 (hereinafter referred to as positive and negative current collectors) by being bonded or coupled (for example, by welding) to the positive uncoated portion 212a and the negative electrode uncoated portion 214a, respectively.

For example, the positive and negative electrode terminals 130_1 and 130_2 may be coupled by welding to the positive and negative electrode current collectors 222 and 224, respectively. However, the present disclosure is not limited thereto, and the positive and negative electrode terminals 130_1 and 130_2 and the positive and negative electrode current collectors 222 and 224 may be integrally formed in one or more embodiments.

In addition, an insulation member may be installed between the electrode assembly 210 and the cap plate 122. The insulation member may include first and second lower insulation members 60 and 70, and each of the first and second lower insulation members 60 and 70 may also have a portion located between the electrode assembly 210 and the case 110.

In addition, according to one or more embodiments of the present disclosure, one end of a separation member may face one side of the electrode assembly 210 and may be installed between the insulation member and the positive or negative electrode terminals 130_1 and 130_2.

In one or more embodiments, the separation member may include first and second separation members 242 and 244.

Accordingly, the positive and negative electrode terminals 130_1 and 130_2, which may be coupled by welding to the positive and negative electrode current collectors 222 and 224, may be coupled to first ends of the first and second lower insulation members 232 and 234 and the first and second separation members 242 and 244.

The battery cell 10 may be a lithium battery cell, a sodium battery cell, or the like. However, the scope of the present disclosure is not limited thereto, and the battery cell 10 includes any type of cell that can repeatedly provide electricity by charging and discharging. In embodiments, if the battery cell 10 is a lithium battery cell, it can be used in electric vehicles (EVs) because it has excellent lifespan and high-rate performance. For example, it can be used in hybrid vehicles such as plug-in hybrid electric vehicles (PHEVs). In addition, lithium battery cells can be used in applications that require a large amount of power storage. For example, they can be used in electric bicycles, electric tools, energy storage systems (ESS), and similar devices.

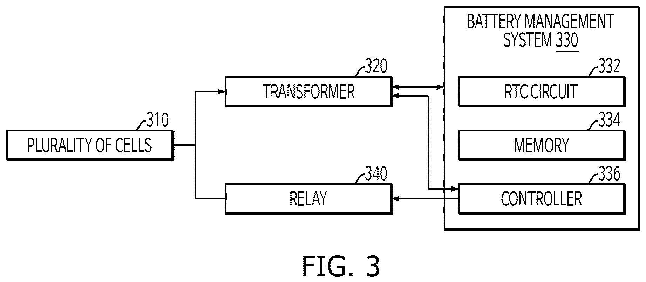

FIG. 3 is a diagram illustrating an example of an unauthorized cell replacement prevention system according to embodiments of the present disclosure. In embodiments, the unauthorized cell replacement prevention system may include a plurality of cells 310, a transformer (for example, a DC/DC converter) 320 connected to the plurality of cells 310, a relay 340, and a battery management system 330 that controls the plurality of cells 310, the transformer 320, and the relay 340. In one example, the battery management system 330 may include a Real Time Clock (RTC) circuit 332, a memory 334, and a controller 336.

In embodiments, the controller 336 may store first time information generated by the RTC circuit 332 in the memory 334. Here, the memory 334 may be a nonvolatile memory. In addition, the first time information may be stored in the memory 334 at predetermined intervals (for example, 4 to 10 seconds) during the operation of the battery management system 330. For example, the predetermined interval may be determined based on the cycle of the memory 334.

In embodiments, the plurality of cells 310 may supply power to the battery management system 330 and the RTC circuit 332 through the transformer 320. That is, the RTC circuit 332 does not depend on an auxiliary battery and may be driven by power supplied from the plurality of cells 310. Accordingly, the power supplied to the RTC circuit 332 may be cut off when at least some of the plurality of cells 310 are replaced. In addition, the RTC circuit 332 may be initialized when the power supplied to the RTC circuit 332 is cut off. For example, the time information generated by the RTC circuit 332 may be initialized.

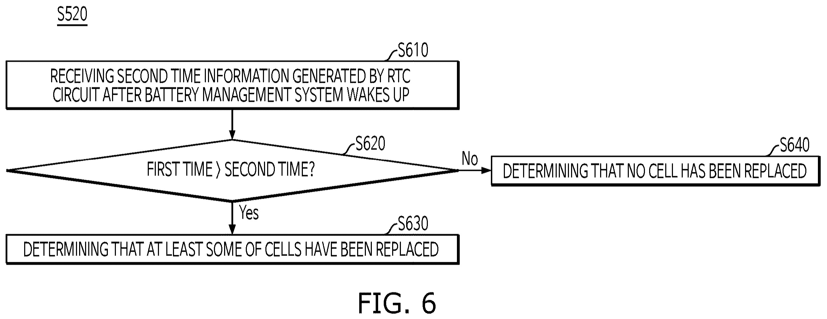

In embodiments, when the battery management system 330 wakes up after at least some of the plurality of cells 310 are replaced, the controller 336 may determine whether at least some of the plurality of cells 310 have been replaced based on the first time information. Specifically, the controller 336 may receive the second time information generated by the RTC circuit 332 after the battery management system 330 wakes up. In addition, the controller 336 may determine whether at least some of the plurality of cells 310 have been replaced based on the first time information stored in the memory 334 and the received second time information. An example of determining whether the cells have been replaced will be described in detail later with reference to FIG. 6.

In embodiments, the controller 336 may activate a protection function in response to determining that at least some of the plurality of cells 310 have been replaced. The protection function may include, but is not limited to, opening the relay 340 associated with the battery management system 330. For example, the protection function may include a hardware-based protection function that suspends the operation of the battery management system 330, a software-based protection function (for example, a permanent failure protection function), and the like.

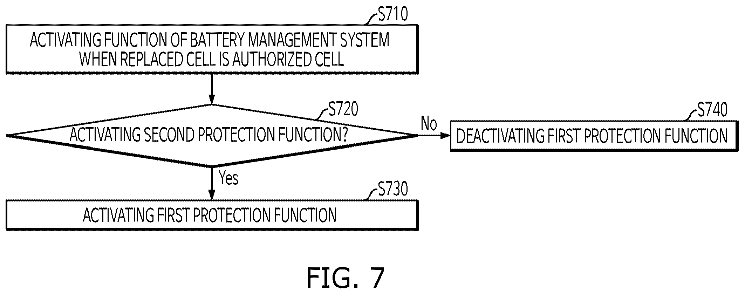

In embodiments, a disable command may be requested to disable the protection function. For example, a disable command may be requested to close the open relay 340. The disable command may include a unique value corresponding to the battery management system 330 and may be received from an external device when the replaced cell is a battery cell authorized by the manufacturer. An example of disabling the protection function using a disable command will be described in detail later with reference to FIG. 7.

In embodiments, the RTC circuit 332 may be connected to the plurality of cells 310 via the transformer 320. In this case, the controller 336 may determine whether the transformer 320 is operating normally based on the output voltage of the transformer 320. In addition, the controller 336 may activate the protection function in response to determining that the transformer 320 is operating abnormally.

With this configuration, whether a cell has been replaced can be detected using the time information of the RTC circuit. By activating the protection function when a cell is replaced, the operation of the battery management system can be stopped unless a disable command is issued. Accordingly, the operation of the battery management system using an unauthorized cell can be stopped, and replacement of an unauthorized cell can be prevented.

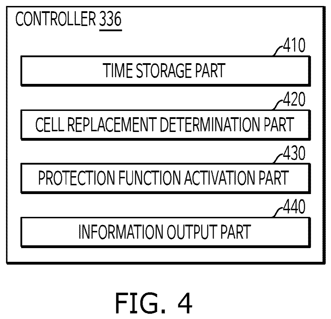

FIG. 4 is a diagram illustrating an example of a configuration of the controller 336 according to embodiments of the present disclosure. In embodiments, the controller (or at least one processor of the controller) 336 may include a time storage part 410, a cell replacement determination part 420, a protection function activation part 430, and an information output part 440. Here, the time storage part 410 may store time information generated by the RTC circuit (for example, 332 of FIG. 3) in the memory (for example, 334 of FIG. 3). In addition, the time storage part 410 may store time information in the memory at predetermined intervals during the operation of the battery management system. Additionally, the time storage part 410 may store time information generated after the RTC circuit is initialized in the memory. Here, the memory may be a nonvolatile memory.

The cell replacement determination part 420 may determine whether at least some of the plurality of cells associated with the battery management system have been replaced based on the first time information stored in the memory by the time storage part 410 when the battery management system wakes up. Specifically, the cell replacement determination part 420 may receive the second time information generated by the RTC circuit after the battery management system wakes up. In addition, the cell replacement determination part 420 may determine whether at least some of the plurality of cells have been replaced based on the first time information stored in the memory and the second time information generated by the RTC circuit after the battery management system wakes up. For example, the cell replacement determination part 420 may determine that at least some of the plurality of cells have been replaced if the first time is greater than the second time.

The protection function activation part 430 may activate the first protection function in response to determining that at least some of the plurality of cells have been replaced. Here, the first protection function may include opening the relay (for example, 340 of FIG. 3) associated with the battery management system. While the protection function is operating, the operation of the battery management system may be stopped.

In embodiments, the protection function activation part 430 may determine whether the transformer is operating normally based on the output voltage of the transformer (for example, 320 of FIG. 3). In addition, in response to determining that the transformer is operating abnormally, the protection function activation part 430 may activate the first protection function.

In embodiments, the protection function activation part 430 may disable the first protection function. Specifically, the protection function activation part 430 may determine the first protection function in response to the replaced cell being an authorized cell. In this case, the protection function activation part 430 may determine whether the second protection function of the battery management system is operating. Here, the second protection function may include a protection function that suspends the operation of the battery management system through software control, such as a permanent failure protection function of the battery management system. This second protection function may be activated by a cause of suspension other than cell replacement, such as overvoltage of the cell or charge imbalance of the cell. Accordingly, when the second protection function is activated, the protection function activation part 430 may activate or maintain the first protection function. Alternatively, the protection function activation part 430 may disable the first protection function when the second protection function is not operating.

In embodiments, the protection function activation part 430 may receive a disable command from an external device (for example, a server associated with a manufacturer) when the replaced cell is an authorized cell. Here, the disable command may include a unique value corresponding to the battery management system. Based on the disable command, the protection function activation part 430 may disable the first protection function. That is, the protection function activation part 430 may close the relay, and the battery management system may operate normally. In this case, the time storage part 410 may store the time information generated by the RTC circuit in the memory at predetermined intervals.

The information output part 440 may output information associated with the battery management system in response to determining that at least some of the plurality of cells have been replaced. For example, the information associated with the battery management system may include identification information of each of the plurality of cells, information associated with a battery assembly equipped with the battery management system, a notification that at least some of the plurality of cells have been replaced, and the like. Such information associated with the battery management system may be transmitted to an external device.

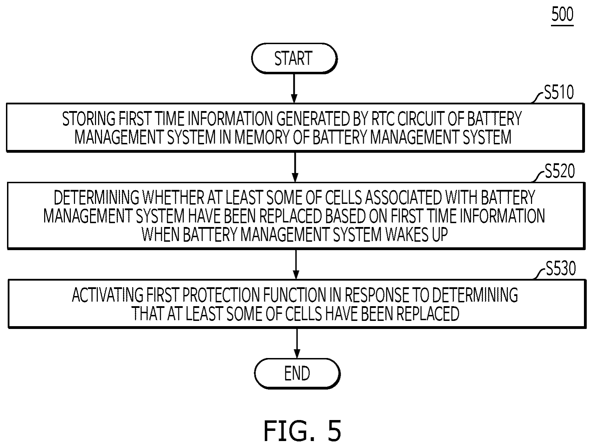

FIG. 5 is a flowchart illustrating an example of an unauthorized cell replacement prevention method 500 according to embodiments of the present disclosure. In embodiments, the unauthorized cell replacement prevention method 500 may be initiated by the controller (for example, 336 of FIG. 3) storing first time information generated by the RTC circuit of the battery management system in the memory of the battery management system (S510). Here, the first time information may be stored in the memory at predetermined intervals during the operation of the battery management system. In addition, a plurality of cells may supply power to the RTC circuit. Additionally, the memory may be a nonvolatile memory.

Thereafter, the controller may determine whether at least some of the plurality of cells associated with the battery management system have been replaced based on the first time information when the battery management system wakes up (S520). Specifically, the controller may receive second time information generated by the RTC circuit after the battery management system wakes up. In addition, the controller may determine whether at least some of the plurality of cells have been replaced based on the first time information stored in the memory and the received second time information. An example of determining whether cells have been replaced will be described in detail later with reference to FIG. 6.

Then, the controller may operate the first protection function in response to determining that at least some of the plurality of cells have been replaced (S530). Here, the first protection function may include opening a relay associated with the battery management system. In addition, the controller may output information associated with the battery management system in response to determining that at least some of the plurality of cells have been replaced.

In embodiments, the controller may store third time information generated from the RTC circuit in the memory when the replaced cell is an authorized cell. Here, the third time information may be time information generated after the RTC circuit is initialized.

In embodiments, the controller may determine whether to disable the first protection function when the replaced cell is an authorized cell. Specifically, the controller may determine whether to disable the first protection function based on whether the second protection function of the battery management system is operating. An example of determining whether to disable the first protection function based on whether the second protection function is operating will be described in detail later with reference to FIG. 7.

In embodiments, the power supplied to the RTC circuit may be cut off when at least some of the plurality of cells are replaced. In addition, the RTC circuit may be initialized when the power supplied to the RTC circuit is cut off.

FIG. 6 is a diagram illustrating an example of a method (S520) for determining whether at least some of the plurality of cells have been replaced according to embodiments of the present disclosure. In embodiments, the controller may determine whether at least some of the plurality of cells associated with the battery management system have been replaced based on first time information generated by the RTC circuit stored in the memory when the battery management system wakes up. The method (S520) for determining whether at least some of the plurality of cells have been replaced may be initiated by the controller receiving second time information generated by the RTC circuit after the battery management system wakes up (S610).

Thereafter, the controller may determine whether at least some of the plurality of cells have been replaced based on the first time information stored in the memory and the received second time information. Specifically, the controller may determine whether the first time is greater than the second time (S620). If the first time is greater than the second time, the controller may determine that at least some of the plurality of cells have been replaced (S630). If the cells are replaced, the power supplied to the RTC circuit is cut off and the RTC circuit is initialized, so the first time stored in the nonvolatile memory may be greater than the second time. Conversely, if the first time is not greater than the second time, the controller may determine that the cells have not been replaced (S640).

FIG. 7 is a diagram illustrating an example of a method for disabling a first protection function according to embodiments of the present disclosure. In embodiments, the controller may activate the first protection function in response to determining that at least some of the plurality of cells have been replaced. Here, the first protection function may include opening a relay associated with the battery management system.

In embodiments, the method of disabling the first protection function may be initiated by the controller activating the function of the battery management system when the replaced cell is an authorized cell (S710). Thereafter, the controller may determine whether the second protection function of the battery management system is operating (S720). Here, the second protection function may include a protection function that suspends the operation of the battery management system through software control, such as a permanent failure protection function of the battery management system.

In embodiments, when the second protection function is operating, the battery management system does not operate normally, so the controller may activate and maintain the first protection function (S730). In addition, when the second protection function is not operating, the battery management system may operate normally, so the controller may deactivate the first protection function (S740).

In embodiments, the controller may receive a disable command from an external device (for example, a server of a manufacturer that checks whether the cell is authorized). Here, the disable command may include a unique value corresponding to the battery management system. In addition, the controller may disable the first protection function based on the disable command. Accordingly, if the replaced cell is an authorized cell, the first protection function may be disabled so that the battery management system may operate normally.

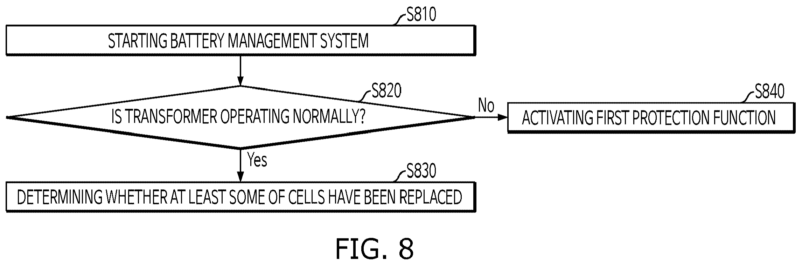

FIG. 8 is a diagram illustrating an example of a method of activating the first protection function depending on whether a transformer is operating normally according to embodiments of the present disclosure. In embodiments, the battery management system may wake up (S810). Here, the RTC circuit may be connected to a plurality of cells through the transformer. In this case, the controller may determine whether the transformer is operating normally based on the output voltage of the transformer (S820). Specifically, if the output voltage of the transformer is higher than a predetermined threshold, the controller may determine that the transformer is operating normally.

In embodiments, if the transformer is operating normally, as described herein in FIG. 6, the controller may determine whether at least some of the plurality of cells have been replaced (S830). If the transformer is not operating normally, the output voltage of the transformer is low, so the controller may activate the first protection function (S840). Accordingly, the operation of the battery management system can be stopped for safety.

The method described herein may be provided as a computer program stored in a computer-readable recording medium for execution on a computer. The medium may be a type of medium that continuously stores a program executable by a computer, or temporarily stores the program for execution or download. In addition, the medium may be a variety of writing means or storage means having a single piece of hardware or a combination of several pieces of hardware, and is not limited to a medium that is directly connected to any computer system, and accordingly, may be present on a network in a distributed manner. An example of the medium includes a medium configured to store program instructions, including a magnetic medium such as a hard disk, a floppy disk, and a magnetic tape, an optical medium such as a CD-ROM and a DVD, a magnetic-optical medium such as a floptical disk, and a ROM, a RAM, a flash memory, and the like. In addition, other examples of the medium may include an app store that distributes applications, a site that supplies or distributes various software, and a recording medium or a storage medium managed by a server.

The methods, operations, or techniques of the present disclosure may be implemented by various means. For example, these techniques may be implemented in hardware, firmware, software, or a combination thereof. Those skilled in the art will further appreciate that various illustrative logical blocks, modules, circuits, and algorithm steps described in connection with the disclosure herein may be implemented in electronic hardware, computer software, or combinations of both. To clearly illustrate this interchangeability of hardware and software, various illustrative components, blocks, modules, circuits, and steps have been described herein generally in terms of their functionality. Whether such a function is implemented as hardware or software varies according to design requirements imposed on the particular application and the overall system. Those skilled in the art may implement the described functions in varying ways for each particular application, but such implementation should not be interpreted as causing a departure from the scope of the present disclosure.

In a hardware implementation, processing units used to perform the techniques may be implemented in one or more ASICs, DSPs, digital signal processing devices (DSPDs), programmable logic devices (PLDs), field programmable gate arrays (FPGAs), processors, controllers, microcontrollers, microprocessors, electronic devices, other electronic units designed to perform the functions described in the present disclosure, computer, or a combination thereof.

Accordingly, various example logic blocks, modules, and circuits described in connection with the present disclosure may be implemented or performed with general purpose processors, DSPs, ASICs, FPGAs or other programmable logic devices, discrete gate or transistor logic, discrete hardware components, or any combination of those designed to perform the functions described herein. The general purpose processor may be a microprocessor, but in the alternative, the processor may be any related processor, controller, microcontroller, or state machine. The processor may also be implemented as a combination of computing devices, for example, a DSP and microprocessor, a plurality of microprocessors, one or more microprocessors associated with a DSP core, or any other combination of the configurations.

In the implementation using firmware and/or software, the techniques may be implemented with instructions stored on a computer-readable medium, such as random access memory (RAM), read-only memory (ROM), nonvolatile random access memory (NVRAM), programmable read-only memory (PROM), erasable programmable read-only memory (EPROM), electrically erasable PROM (EEPROM), flash memory, compact disc (CD), magnetic or optical data storage devices, and the like. The instructions may be executable by one or more processors, and may cause the processor(s) to perform certain aspects of the functions described in the present disclosure.

If implemented in software, the functions may be stored on or transmitted over as one or more instructions or code on a computer-readable medium. Computer-readable media includes both computer storage media and communication media including any medium that facilitates transfer of a computer program from one place to another. A storage media may be any available media that may be accessed by a general purpose or special purpose computer. By way of example, and not limitation, such computer-readable media may comprise RAM, ROM, EEPROM, CD-ROM or other optical disk storage, magnetic disk storage or other magnetic storage devices, or any other medium that may be used to carry or store desired program code means in the form of instructions or data structures and that may be accessed by a general-purpose or special-purpose computer, or a general-purpose or special-purpose processor. Also, any connection is properly termed a computer-readable medium.

For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and blu-ray disc where disks usually reproduce data magnetically, while discs reproduce data optically with lasers. Combinations of the herein should also be included within the scope of computer-readable media.

A software module may reside in RAM memory, flash memory, ROM memory, EPROM memory, EEPROM memory, registers, hard disk, a removable disk, a CD-ROM, or any other form of storage medium known in the art. An example storage medium is coupled to the processor such that the processor may read information from, and/or write information to, the storage medium. In the alternative, the storage medium may be integral to the processor. The processor and the storage medium may reside in an ASIC. The ASIC may reside in a user terminal. In the alternative, the processor and the storage medium may reside as discrete components in a user terminal.

Although the examples described herein have been described as utilizing aspects of the currently disclosed subject matter in one or more standalone computer systems, aspects are not limited thereto, and may be implemented in conjunction with any computing environment, such as a network or distributed computing environment. Furthermore, the aspects of the subject matter in the present disclosure may be implemented in multiple processing chips or apparatus, and storage may be similarly influenced across a plurality of apparatus. Such apparatus may include PCs, network servers, and portable apparatus.

Although the present disclosure has been described herein with respect to embodiments thereof, the present disclosure is not limited thereto. Various modifications and variations can be made thereto by those skilled in the art within the present disclosure and the scope of the appended claims.

## Claims

1. An unauthorized cell replacement prevention method comprising:
storing first time information generated by a Real Time Clock, RTC, circuit (332) of a battery management system (330) in a memory (334) of the battery management system (330);
determining whether at least some of a plurality of cells (310) associated with the battery management system (330) have been replaced based on the first time information when the battery management system (330) wakes up; and
activating a first protection function in response to determining that at least some of the plurality of cells (310) have been replaced, wherein
the plurality of cells (310) supply power to the RTC circuit (332).

2. The unauthorized cell replacement prevention method as claimed in claim 1, wherein the first time information is stored in the memory (334) at predetermined intervals during operation of the battery management system (330).

3. The unauthorized cell replacement prevention method as claimed in claim 1 or 2, wherein the determining whether at least some of the plurality of cells (310) have been replaced comprises:
receiving second time information generated by the RTC circuit (332) after the battery management system (330) wakes up; and
determining whether at least some of the plurality of cells (310) have been replaced based on the first time information stored in the memory (334) and the received second time information.

4. The unauthorized cell replacement prevention method as claimed in claim 3, wherein the determining whether at least some of the plurality of cells (310) have been replaced based on the second time information comprises:
determining that at least some of the plurality of cells (310) have been replaced if the first time is greater than the second time.

5. The unauthorized cell replacement prevention method as claimed in any one of claims 1 to 4, wherein the first protection function includes opening a relay (340) associated with the battery management system (330).

6. The unauthorized cell replacement prevention method as claimed in any one of claims 1 to 5, wherein the RTC circuit (332) is connected to the plurality of cells (310) through a transformer (320), and the method further comprises:
determining whether the transformer (320) is operating normally based on an output voltage of the transformer (320); and
activating the first protection function in response to determining that the transformer (320) is operating abnormally.

7. The unauthorized cell replacement prevention method as claimed in any one of claims 1 to 6, further comprising storing third time information generated from the RTC circuit (332) in the memory (334) when at least one of the replaced cells is an authorized cell.

8. The unauthorized cell replacement prevention method as claimed in claim 7, wherein the third time information is generated after the RTC circuit (332) is initialized.

9. The unauthorized cell replacement prevention method as claimed in any one of claims 1 to 8, further comprising determining whether to disable the first protection function when at least one of the replaced cells is an authorized cell.

10. The unauthorized cell replacement prevention method as claimed in claim 9, wherein the determining whether to disable the first protection function comprises determining whether to activate a second protection function of the battery management system (330).

11. The unauthorized cell replacement prevention method as claimed in claim 10, wherein the determining whether to disable the first protection function further comprises disabling the first protection function if the second protection function is not operating.

12. The unauthorized cell replacement prevention method as claimed in claim 10 or 11, wherein the determining whether to disable the first protection function further comprises activating the first protection function if the second protection function is operating.

13. The unauthorized cell replacement prevention method as claimed in claim 9, 10, or 11, wherein the disabling the first protection function comprises:
receiving a disable command from an external device; and
disabling the first protection function based on the disable command.

14. An unauthorized cell replacement prevention system comprising:
a plurality of cells (310); and
a battery management system (330) for controlling the plurality of cells (310), wherein
the battery management system (330) includes an RTC circuit (332), a memory (334), and a controller (336),
the plurality of cells (310) configured to supply power to the RTC circuit (332),
the controller (336) is configured to:
store first time information generated by the RTC circuit (332) in the memory (334) of the battery management system (330);
determine whether at least some of the plurality of cells (310) associated with the battery management system (330) have been replaced based on the first time information when the battery management system (330) wakes up; and
activate a first protection function in response to determining that at least some of the plurality of cells (310) have been replaced.

15. The unauthorized cell replacement prevention system as claimed in claim 14, wherein:
the controller (336) is configured to:
receive second time information generated by the RTC circuit (332) after the battery management system (330) wakes up; and
determine whether at least some of the plurality of cells (310) have been replaced based on the first time information stored in the memory (334) and the received second time information.
